(19) Europäisches Patentamt
European Patent Office
Office européen des brevets

(11) EP 3 573 435 A1

## EUROPEAN PATENT APPLICATION
published in accordance with Art. 153(4) EPC

(43) Date of publication:
27.11.2019 Bulletin 2019/48

(51) Int Cl.:
H05K 1/14 (2006.01)     G09F 9/00 (2006.01)

(21) Application number: 18741799.3

(86) International application number:
PCT/JP2018/001154

(22) Date of filing: 17.01.2018

(87) International publication number:
WO 2018/135519 (26.07.2018 Gazette 2018/30)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 17.01.2017   JP 2017005654

(71) Applicant: Fujikura Ltd.
Tokyo 135-8512 (JP)

(72) Inventor: SUTO, Yuki
Sakura-shi
Chiba 285-8550 (JP)

(74) Representative: Ter Meer Steinmeister & Partner
Patentanwälte mbB
Artur-Ladebeck-Strasse 51
33617 Bielefeld (DE)

(54)     **WIRING BODY AND WIRING BODY ASSEMBLY**

(57)     A first wiring body 50 includes a first resin portion 51, a conductive portion 52 that is formed on an upper surface of the first resin portion and includes at least a first terminal portion 523, and a second resin portion 53 that is formed on the upper surface of the first resin portion to cover the conductive portion, the second resin portion includes a first opening portion 531 from which the first terminal portion is exposed, and an end face 532 of the second resin portion that defines the first opening portion includes a lower side face 533, an upper side face 534 that is farther from the first resin portion than the lower side face, and an edge portion 535 that connects the lower side face and the upper side face.

FIG. 4

## Description

TECHNICAL FIELD

The present invention relates to a wiring body and a wiring body assembly in which two wiring bodies are connected by a conductive bonding portion.

For designated countries that are permitted to be incorporated by reference in the literature, the contents described in Japanese Patent Application No. 2017-005654 filed in Japan on January 17, 2017 is incorporated herein by reference and made a part of the description of this specification.

BACKGROUND ART

As a connection structure of a silver electrode terminal of a color plasma display panel and a flexible printed circuit (hereinafter, referred to as FPC), a structure in which an exposed part of the silver electrode terminal is sealed with a resin is known (for example, see Patent Document 1).

CITATION LIST

PATENT DOCUMENT

Patent Document 1: JP 2001-015042 A

SUMMARY OF THE INVENTION

PROBLEM TO BE SOLVED BY THE INVENTION

In a connection structure of an FPC and a wiring body that includes a first resin portion, a conductive portion including a terminal portion formed on a surface of the first resin, and a second resin portion covering the conductive portion excluding the terminal portion, in a case where an exposed part of the terminal portion of the wiring body is sealed with a sealing resin, a problem arises in that the sealing resin is wetted and spreads on an upper face of the second resin portion to impair flatness of the entire wiring body.

The problem to be solved by the invention is to provide a wiring body and a wiring body assembly that are excellent in flatness.

MEANS FOR SOLVING PROBLEM

[1] A wiring body according to the invention is a wiring body including: a first insulating portion; a conductive portion that is formed on one surface of the first insulating portion and includes at least a terminal portion; and a second insulating portion that is formed on the one surface to cover the conductive portion, in which the second insulating portion includes an opening portion from which the terminal portion is exposed, and an end face of the second insulating portion that defines the opening portion includes: a first face; a second face that is farther from the first insulating portion than the first face; and an edge portion that connects the first face and the second face.

[2] In the invention, the edge portion may be continuously formed along a horizontal direction over the entire region of the end face.

[3] In the invention, a convex portion may be formed in the end face by the edge portion protruding toward the inside of the opening portion, the first face may include a curved portion that approaches the edge portion as being separated from the first insulating portion and is curved toward the inner side of the convex portion, the curved portion may include: a first part; and a second part that is farther from the edge portion than the first part, and a curvature radius of the first part may be smaller than a curvature radius of the second part.

[4] In the invention, a protrusion portion that protrudes toward the inside of the opening portion may be formed at a lower end of the second face.

[5] A wiring body assembly according to the invention is a wiring body assembly including: the above-described first wiring body; a second wiring body that includes a substrate and a connection terminal portion formed on the other surface of the substrate, the connection terminal portion being overlapped with the first wiring body in the opening portion to face the terminal portion; and a conductive bonding portion that is formed between the terminal portion and the connection terminal portion and connects the terminal portion and the connection terminal portion, in which a gap is formed between the second wiring body and the end face by the second wiring body and the end face being separated from each other, and the wiring body assembly includes a sealing resin filled in at least the gap.

[6] In the invention, it is preferable that the sealing resin is not in contact with the second face.

[7] In the invention, the sealing resin may be in contact with one surface of the second wiring body.

[8] In the invention, the following Expression (1) may be satisfied:

$$H_2 > H_3 \cdots (1)$$

in the above Expression (1), $H_2$ is a height from the one surface of the first insulating portion to one surface of the second insulating portion, and $H_3$ is a height from one surface of the first insulating portion to the edge portion.

[9] In the invention, the following Expression (2) is satisfied:

$$H_3 < H_4 \cdots (2)$$

in the above Expression (2), $H_3$ is a height from the one surface of the first insulating portion to the edge portion, and $H_4$ is a height from the one surface of the first insulating portion to one surface of the second wiring body.

[10] In the invention, the following Expression (3) is satisfied:

$$H_2 > t_1 \cdots (3)$$

$H_2$ is a height from the one surface of the first insulating portion to one surface of the second insulating portion, and $t_1$ is a maximum thickness of the sealing resin.

EFFECT OF THE INVENTION

According to the invention, since wetting and spreading of the sealing resin on an upper face of the second resin portion can be suppressed, a wiring body excellent in flatness can be obtained.

BRIEF DESCRIPTION OF DRAWINGS

Fig. 1 is a plan view illustrating a touch sensor according to an embodiment of the invention;
Fig. 2 is an exploded perspective view of the touch sensor;
Fig. 3 is a plan view illustrating a connection part of a first wiring body and a second wiring body in an enlarged manner;
Fig. 4 is a cross-sectional view taken along the line IV-IV of Fig. 3;
Fig. 5 is a cross-sectional view taken along the line V-V of Fig. 3;
Fig. 6 is a perspective view of a first opening portion and a second opening portion when viewed from the upper side;
Fig. 7 is a partially enlarged view of a part VII of Fig. 4;
Fig. 8 is a cross-sectional view (part 1) for describing a method of connecting the first wiring body and the second wiring body;
Fig. 9 is a cross-sectional view (part 2) for describing a method of connecting the first wiring body and the second wiring body;
Fig. 10 is a cross-sectional view illustrating a relation between a surface tension and a contact angle in an end face;
Fig. 11 is a cross-sectional view illustrating a relation between a surface tension and a contact angle at an edge portion;
Fig. 12 is a cross-sectional view illustrating a connection part of a first wiring body and a second wiring body according to another embodiment of the invention in an enlarged manner;
Fig. 13 is a cross-sectional view illustrating a connection part of a first wiring body and a second wiring body according to still another embodiment of the invention in an enlarged manner; and
Fig. 14 is a cross-sectional view illustrating a connection part of a first wiring body and a second wiring body according to still another embodiment of the invention in an enlarged manner.

MODE(S) FOR CARRYING OUT THE INVENTION

Hereinafter, embodiments of the invention will be described on the basis of drawings.

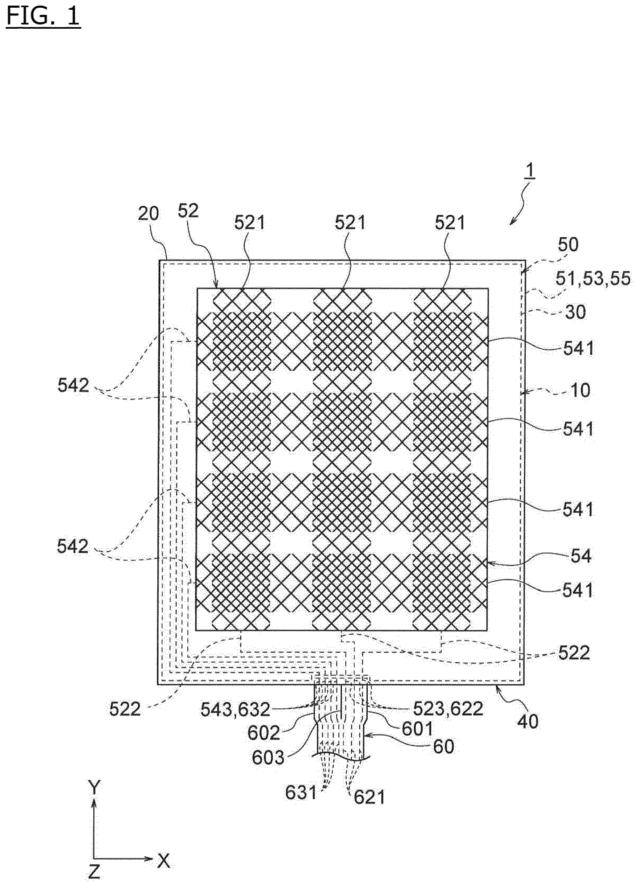

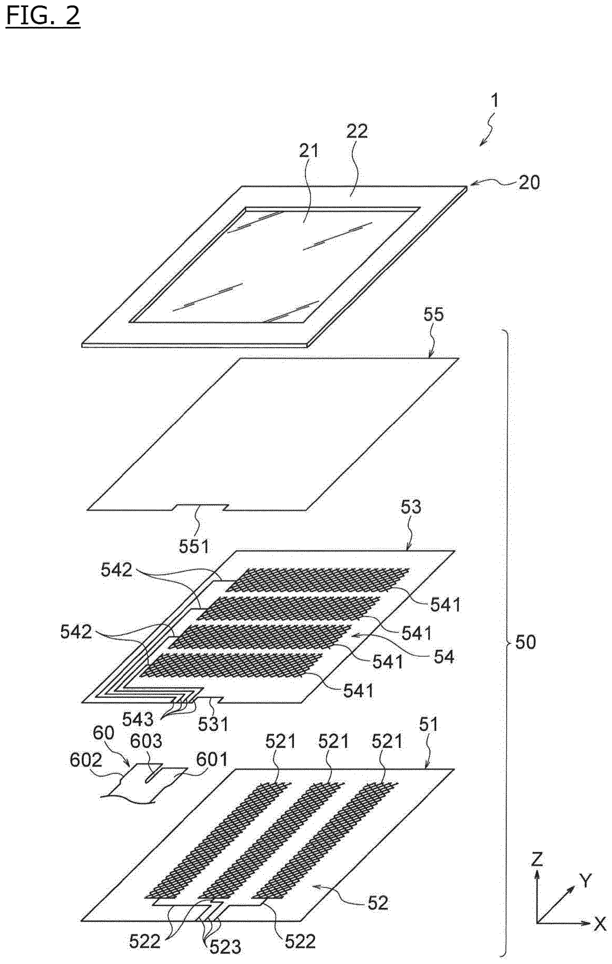

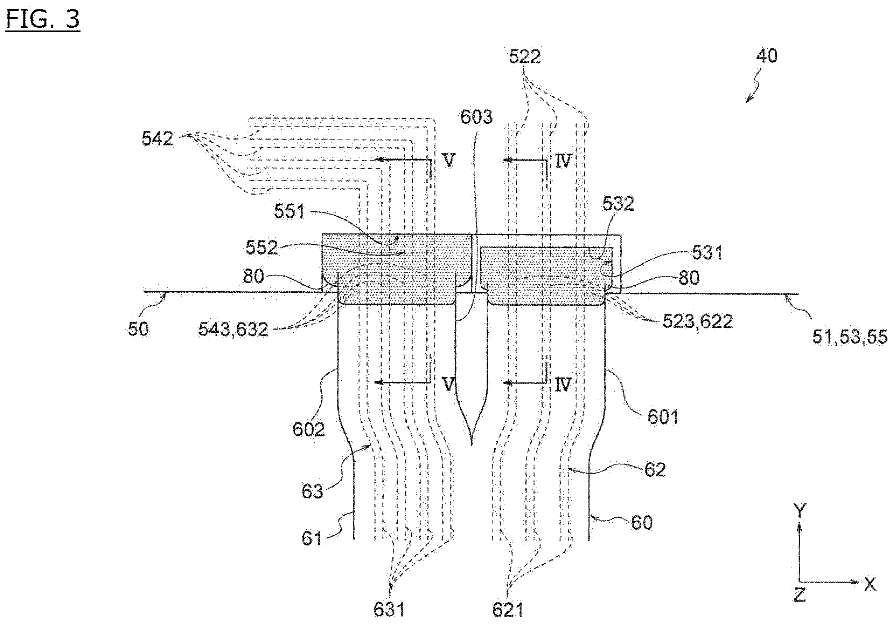

Fig. 1 is a plan view illustrating a touch sensor according to an embodiment of the invention, Fig. 2 is an exploded perspective view of the touch sensor, and Fig. 3 is a plan view illustrating a connection part of a first wiring body and a second wiring body in an enlarged manner.

A touch sensor 1 illustrated in Fig. 1 is a touch panel sensor corresponding to a projection-type capacitive sensing method, and for example, is used as an input device having a function of detecting a touch position in combination with a display device (not illustrated) or the like. The display device is not particularly limited, and a liquid crystal display, an organic EL display, an electronic paper, or the like can be used as the display device. This touch sensor 1 has a detection electrode and a driving electrode (first and second electrode portions 521 and 541 which will be described later) that are disposed to face each other, and a predetermined voltage is periodically applied to between the two electrodes from an external circuit (not illustrated) via a second wiring body 60.

In such a touch sensor 1, for example, as an operator's finger (external conductor) approaches the touch sensor 1, a capacitance (electrostatic capacitance) is formed between the external conductor and the touch sensor 1, so that an electric state between the two electrodes changes. The touch sensor 1 can detect an operation position of the operator on the basis of an electric change between the two electrodes.

As illustrated in Fig. 1 and Fig. 2, the touch sensor 1 includes a cover panel 20, a transparent adhesive layer 30, and a wiring body assembly 40 that is provided on one surface of the cover panel 20 via the transparent adhesive layer 30.

The cover panel 20 has a rectangular outer shape and includes: a transparent portion 21 that allows transmission of visible light rays; and a shielding portion 22 that shields visible light rays. The transparent portion 21 is formed in a rectangular shape, and the shielding portion 22 is formed in a rectangular frame shape around the transparent portion 21. Examples of a transparent material forming the cover panel 20 may include glass materials such as soda-lime glass and borosilicate glass and resin materials such as polymethylmethacrylate (PMMA) and polycarbonate (PC). Further, the shielding portion 22 is formed at an outer circumference portion of a rear surface of the cover panel 20, for example, by applying black ink. A first wiring body 50 (described later) of the wiring body assembly 40 is pasted on the cover panel 20, and this first wiring body 50 is supported by the cover panel 20. In this case, it is preferable that the cover panel 20 has a stiffness enough to support the first wiring body 50.

The transparent adhesive layer 30 is interposed between the cover panel 20 and the wiring body assembly 40. This transparent adhesive layer 30 is an optical transparent adhesive film and can be formed using a known adhesive such as a silicone resin-based adhesive, an acrylic resin-based adhesive, a urethane resin-based adhesive, or a polyester resin-based adhesive. In this embodiment, although the transparent adhesive layer 30 is formed on the lower surface of the cover panel 20 in advance, in a case where a layer of the wiring body assembly 40 at the cover panel 20 side is an adhesive layer, formation of the transparent adhesive layer 30 is not necessary, so that the transparent adhesive layer 30 may be omitted.

As illustrated in Fig. 1 to Fig. 3, the wiring body assembly 40 includes the first wiring body 50, the second wiring body 60, a conductive bonding portion 70, and a sealing resin 80.

As illustrated in Fig. 2, the first wiring body 50 includes a first resin portion 51, a first conductive portion 52, a second resin portion 53, a second conductive portion 54, and a third resin portion 55. This first wiring body 50 is configured to have transparency (translucency) as a whole in order to secure visibility of the display device.

The first resin portion 51 has a rectangular outer shape and is made of a resin material having transparency. Examples of this resin material having transparency may include UV curable resins, thermosetting resins, or thermoplastic resins such as an epoxy resin, an acrylic resin, a polyester resin, a urethane resin, a vinyl resin, a silicone resin, a phenol resin, and a polyimide resin.

The first conductive portion 52 is provided on the upper surface of the first resin portion 51 (a surface, which is positioned at a side facing the second wiring body 60 (specifically, a first branch portion 601 (described later)), of main surfaces of the first resin portion 51), and is held by the first resin portion 51. This first conductive portion 52 includes a plurality of first electrode portions 521, a plurality of first lead wirings 522, and a plurality of first terminal portion 523. The first electrode portion 521 has a mesh shape. Each first electrode portions 521 extends in a Y direction in the drawing, and the plurality of first electrode portions 521 are juxtaposed in an X direction in the drawing. One end of the first lead wiring 522 is connected to one longitudinal direction end of each first electrode portion 521. The first terminal portion 523 is connected to other end of each first lead wiring 522.

The number of the first electrode portions 521 is not particularly limited, but can be arbitrarily set. Further, the number of the first lead wiring 522 and the number of the first terminal portions 523 are set depending on the number of the first electrode portions 521.

The first conductive portion 52 is made of a conductive material (conductive particles) and a binder resin. Examples of the conductive material may include metal materials such as silver, copper, nickel, tin, bismuth, zinc, indium, and palladium, and carbon-based materials such as graphite, carbon black (furnace black, acetylene black, Ketjen black), carbon nanotube, and carbon nanofiber. A metal salt may be used as the conductive material. As the metal salt, salts of the aforementioned metals can be exemplified. Examples of the binder resin may include an acrylic resin, a polyester resin, an epoxy resin, a vinyl resin, a urethane resin, a phenol resin, a polyimide resin, a silicone resin, and a fluoride resin. Such a first conductive portion 52 is formed by applying and curing a conductive paste. Specific examples of such a conductive paste may include a conductive paste formed by mixing the aforementioned conductive material and binder resin with water or a solvent and various additives. Examples of a solvent contained in the conductive paste may include $\alpha$-terpineol, butyl carbitol acetate, butyl carbitol, 1-decanol, butyl cellosolve, diethylene glycol monoethyl ether acetate, and tetradecane. The binder resin may be omitted from materials forming the first conductive portion 52.

The second resin portion 53 has a rectangular outer shape and is formed by a resin material having transparency. As the resin material having transparency, for example, the same materials as the resin materials forming the first resin portion 51 described above can be used.

The second resin portion 53 is formed to cover the upper surface of the first resin portion 51, the first electrode portion 521, and the first lead wiring 522. The second resin portion 53 is formed with a first opening portion 531, and the first terminal portion 523 is exposed from this first opening portion 531.

The second conductive portion 54 is provided on the upper surface of the second resin portion 53 (a surface, which is positioned at a side facing the second wiring body 60 (specifically, a second branch portion 602 (described later)), of main surfaces of the second resin portion 53). This second conductive portion 54 includes a plurality of second electrode portions 541, a plurality of second lead wirings 542, and a plurality of second terminal portions 543. The second electrode portion 541 has a mesh shape. Each second electrode portion 541 extends in the X direction in the drawing, and the plurality of second electrode portions 541 are juxtaposed in the Y direction in the drawing. One end of the second lead wiring 542 is connected to one longitudinal direction end of each second electrode portion 541. Each second lead wiring 542 extends from one longitudinal direction end of each second electrode portion 541 to a connection part with the second wiring body 60. The second terminal portion 543 is connected to other end of each second lead wiring 542.

The number of the second electrode portions 541 is not particularly limited, but can be arbitrarily set. Further, the number of the second lead wirings 542 and the number of the second terminal portions 543 are set depending on the number of the second electrode portions 541.

The second conductive portion 54 is made of a conductive material (conductive particles) and a binder resin similarly to the first conductive portion 52. Such a second conductive portion 54 is also formed by applying and curing a conductive paste similarly to the first conductive portion 52.

The third resin portion 55 has a rectangular outer shape and is made of a resin material having transparency. As the resin material having transparency, for example, the same materials as the resin materials forming the first resin portion 51 described above can be used.

The third resin portion 55 is formed to cover the upper surface of the second resin portion 53, the second electrode portion 541, and the second lead wiring 542. The third resin portion 55 is formed with a second opening portion 551, and the second terminal portion 543 is exposed from this second opening portion 551.

Further, the upper surface of the third resin portion 55 is formed to be substantially flat. This upper surface of the third resin portion 55 is pasted to the cover panel 20 via the transparent adhesive layer 30.

The second wiring body 60 is a flexible printed circuit (FPC). In this embodiment, as illustrated in Fig. 3, a slit 603 is formed at the width direction center of the one longitudinal direction end of the second wiring body 60, and the one longitudinal direction end of the second wiring body 60 is bisected by the slit 603. One side (the first branch portion 601) of one longitudinal direction end of the second wiring body 60 corresponds to the first terminal portion 523. Meanwhile, the other side (the second branch portion 602) of one longitudinal direction end of the second wiring body 60 corresponds to the second terminal portion 543.

This second wiring body 60 includes: a strip-like substrate 61; and third and fourth conductive portions 62 and 63 that are formed on a lower surface of the substrate 61 (a surface, which is positioned at a side facing the first wiring body 50, of main surfaces of the substrate 61).

The substrate 61 can be formed, for example, from a film material such as polyethylene terephthalate (PET), polyethylene naphthalate (PEN), polyimide resin (PI), or polyetherimide resin (PEI).

The third conductive portion 62 is formed on a lower surface of the first branch portion 601 and includes a plurality of third lead wirings 621 and a plurality of third terminal portions 622. The third lead wiring 621 extends along the first branch portion 601. One longitudinal direction end of the third lead wiring 621 is connected to the third terminal portion 622. The third terminal portion 622 is disposed in the vicinity of the tip end of the first branch portion 601. Each of the plurality of third terminal portions 622 faces each of the plurality of first terminal portions 523.

The fourth conductive portion 63 is formed on a lower surface of the second branch portion 602 and includes a plurality of fourth lead wirings 631 and a plurality of fourth terminal portions 632. The fourth lead wiring 631 extends along the second branch portion 602. One longitudinal direction end of the fourth lead wiring 631 is connected to the fourth terminal portion 632. The fourth terminal portion 632 is disposed in the vicinity of the tip end of the second branch portion 602. Each of the plurality of fourth terminal portions 632 faces each of the plurality of second terminal portions 543.

The second wiring body 60 is not limited to the FPC, and for example, other wiring boards such as a rigid board and a rigid flexible board may be employed.

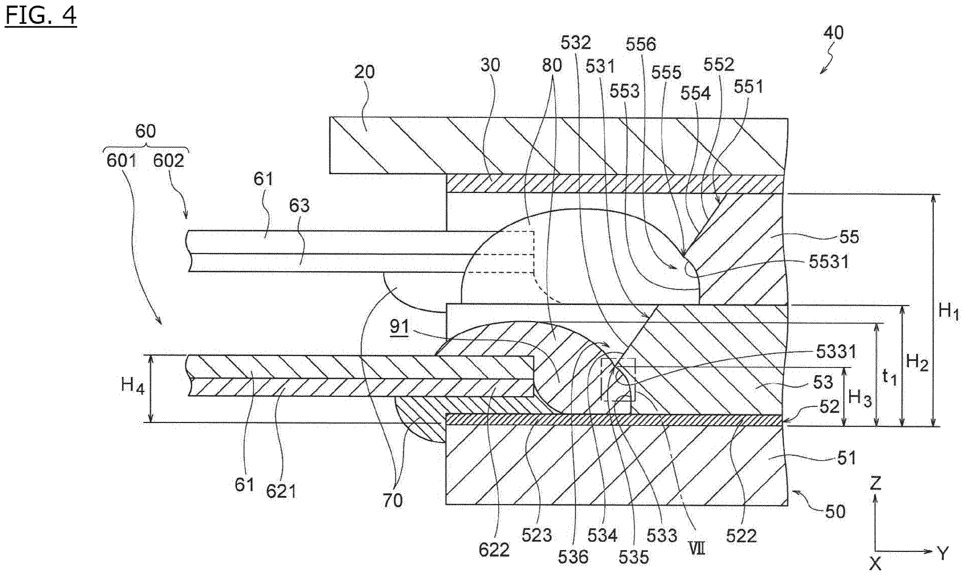

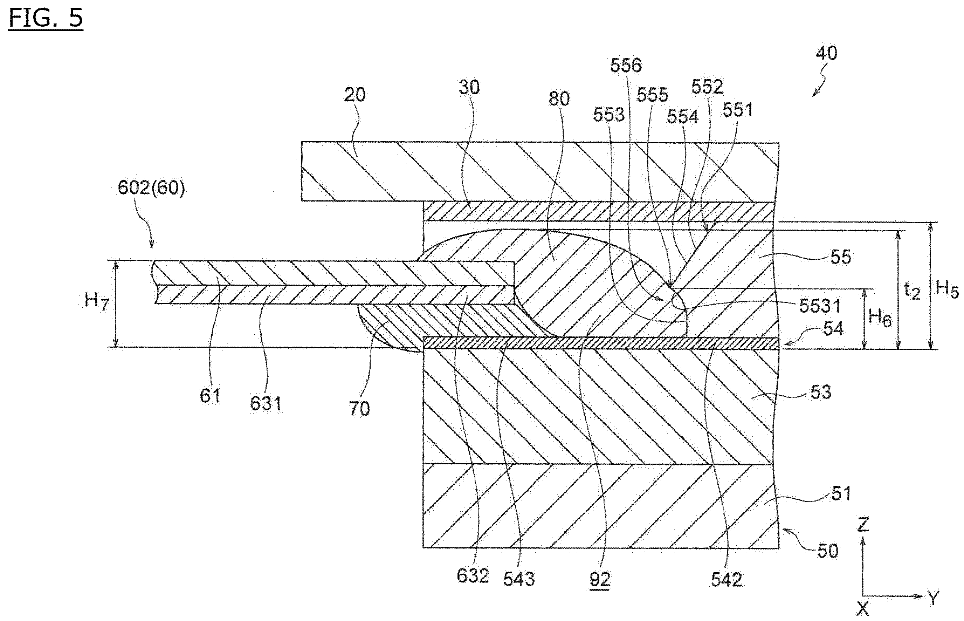

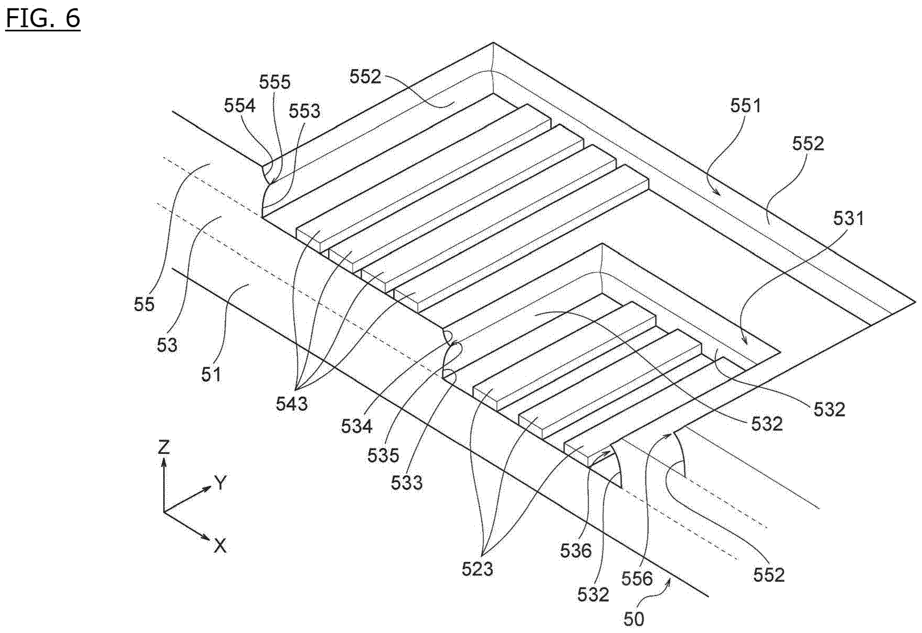

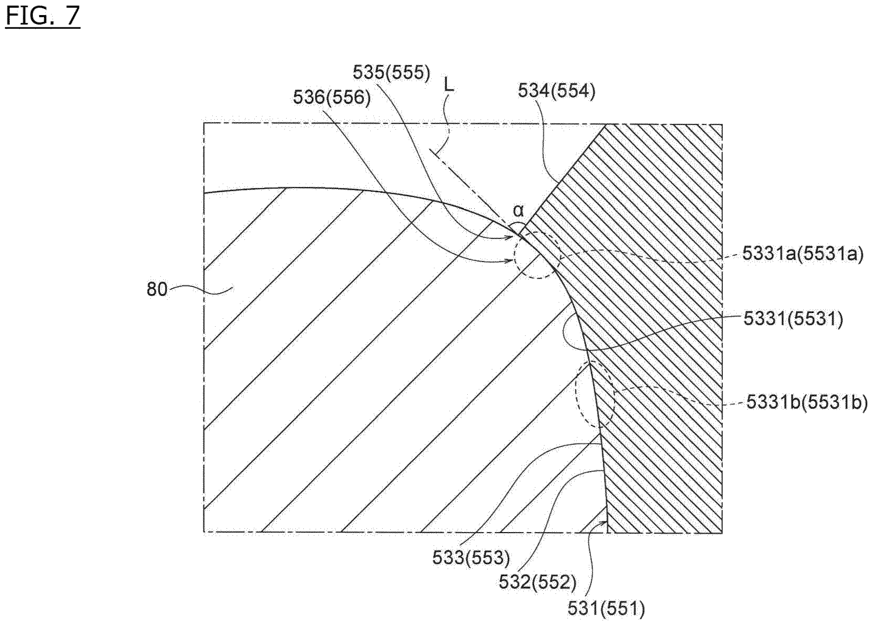

Next, the connection part of the first wiring body 50 and the second wiring body 60 will be described in more detail with reference to Fig. 4 to Fig. 7. Fig. 4 is a cross-sectional view taken along the line IV-IV of Fig. 3, Fig. 5 is a cross-sectional view taken along the line V-V of Fig. 3, Fig. 6 is a perspective view of a first opening portion and a second opening portion when viewed from the upper side, and Fig. 7 is a partially enlarged view of a part VII of Fig. 4.

In this embodiment, as illustrated in Fig. 4, the first wiring body 50 and the tip end of the first branch portion 601 are overlapped in a region of the first opening portion 531. The conductive bonding portion 70 is interposed between the first wiring body 50 and the first branch portion 601, and this conductive bonding portion 70 electrically and mechanically connects the first wiring body 50 (particularly, the first terminal portion 523) and the first branch portion 601 (particularly, the third terminal portion 622).

In a state in which the first wiring body 50 and the tip end of the first branch portion 601 are overlapped, a height $H_2$ from the upper surface of the first resin portion 51 to the upper surface of the second resin portion 53 is larger than a height $H_4$ from the upper surface of the first resin portion 51 to the upper surface of the first branch portion 601 (the upper surface of the second wiring body 60) ($H_2 > H_4$). The height $H_4$ is not particularly limited to the above as long as the height $H_4$ is smaller than a height $H_1$ from the upper surface of the first resin portion 51 to the upper surface of the third resin portion 55 ($H_1 > H_4$).

Furthermore, in this embodiment, a height $H_3$ from the upper surface of the first resin portion 51 to an edge portion (a corner portion, a ridge portion) 535 is smaller than the height $H_4$ from the upper surface of the first resin portion 51 to the upper surface of the first branch portion 601 (the upper surface of the second wiring body 60) ($H_3 < H_4$). According to this, since it is difficult for the sealing resin 80 to spread on the upper surface of the second resin portion 53, it is possible to obtain a wiring body that is excellent in flatness.

Similarly, as illustrated in Fig. 5, the first wiring body 50 and the tip end of the second branch portion 602 are overlapped in a region of the second opening portion 551. The conductive bonding portion 70 is interposed between the first wiring body 50 and the second branch portion 602, and this conductive bonding portion 70 electrically and mechanically connects the first wiring body 50 (particularly, the second terminal portion 543) and the second branch portion 602 (particularly, the fourth terminal portion 632).

In a state in which the first wiring body 50 and the tip end of the second branch portion 602 are overlapped, a height $H_5$ from the upper surface of the second resin portion 53 to the upper surface of the third resin portion 55 is larger than a height $H_7$ from the upper surface of the second resin portion 53 to the upper surface of the second branch portion 602 ($H_5 > H_7$).

Examples of such a conductive bonding portion 70 may include an anisotropic conductive film (ACF) and an anisotropic conductive paste (ACP). The first terminal portion 523 and the third terminal portion 622, and the second terminal portion 543 and the fourth terminal portion 632 may electrically and mechanically connected using a metal paste such as a silver paste and a solder paste without using an anisotropic conductive material. In this case, it is necessary to form a plurality of bonding portions at intervals in order to insulate the neighboring terminals.

As illustrated in Fig. 3, the first opening portion 531 is formed in a rectangular shape in plan view and is disposed at one side of the second resin portion 53 (one side positioned at an edge portion of the first wiring body 50 intersecting the first branch portion 601).

As illustrated in Fig. 4, an end face 532 of the second resin portion 53 which defines this first opening portion 531 includes: a lower side face 533; an upper side face 534; and an edge portion 535 that connects the lower side face 533 and the upper side face 534 in cross-sectional view (in cross-sectional view in the case of being cut in a height direction along an extending direction of the first terminal portion 523).

The edge portion 535 protrudes toward the region of the first opening portion 531. According to this, the end face 532 is formed with a convex portion 536 protruding toward the region of the first opening portion 531. A curvature radius of this edge portion 535 is preferably 5 μm or less. The height $H_3$ from the upper surface of the first resin portion 51 to the edge portion 535 is smaller than the height $H_2$ from the upper surface of the first resin portion 51 to the upper surface of the second resin portion 53 ($H_2 > H_3$).

As illustrated in Fig. 6, the edge portion 535 is continuously formed along a horizontal direction over the entire region of three end faces 532 defining the first opening portion 531. Further, also in a part at which two end faces 532 and 532 are connected to each other, the edge portion 535 is continuously formed.

As illustrated in Fig. 4, the lower side face 533 is positioned at the lower side (a side close to the first resin portion 51) with respect to the edge portion 535. The lower side face 533 includes a curved portion 5331 that approaches the edge portion 535 as being separated from the first resin portion 51 and is curved toward the inner side of the convex portion 536. As illustrated in Fig. 7, the curved portion 5331 includes: a first part 5331a close to the edge portion 535; and a second part 5331b that is farther from the edge portion than the first part 5331a, and a curvature radius of the curved portion 5331 varies in these first part 5331a and second part 5331b. Specifically, a curvature radius of the first part 5331a is smaller than a curvature radius of the second part 5331b.

As illustrated in Fig. 4, the upper side face 534 is positioned at the upper side with respect to the lower side face 533 and the edge portion 535 (a side far away from the first resin portion 51). The upper side face 534 extends in a direction different form that of the lower side face 533, and in this embodiment, the upper side face 534 is an inclined face that is inclined to be separated from the edge portion 535 as being separated from the first resin portion 51. In this case, as illustrated in Fig. 7, an angle α formed between a virtual straight line L along the lower side face 533 in the vicinity of the edge portion 535 and the upper side face 534 in the vicinity of the edge portion 535 is a positive value in a case where the clockwise rotation direction about the edge portion 535 is regarded to be positive.

As illustrated in Fig. 4, in the region of the first opening portion 531, the tip end of the first branch portion 601 and the end face 532 of the first opening portion 531 are separated from each other, and according to this, a gap 91 is formed between the first branch portion 601 and the end face 532. In the gap 91, a part of the first terminal portion 523 is exposed from the first branch portion 601, the conductive bonding portion 70 and the second resin portion 53.

In the region of the first opening portion 531 including at least the gap 91, the sealing resin 80 is filled. The first terminal portion 523 exposed from the first branch portion 601, the conductive bonding portion 70 and the second resin portion 53 is covered with the sealing resin 80.

This sealing resin 80 is in contact with the lower side face 533 and the edge portion 535 in an interface with the end face 532 and the first opening portion 531, but the sealing resin 80 is not in contact with the upper side face 534. That is, spreading to a height direction of the sealing resin 80 in the interface with the end face 532 extends to the position of the edge portion 535. In this way, since spreading to the height direction of the sealing resin 80 in the interface with the end face 532 can be set to extend to the position of the edge portion 535 by allowing the upper side face 534 not to be in contact with the sealing resin 80, it is possible to obtain a wiring body that is excellent in flatness.

Meanwhile, the sealing resin 80 spreads on and is in contact with the upper surface of the first branch portion 601 (the upper surface of the second wiring body 60) along the extending direction of the first branch portion 601. In this way, by the sealing resin 80 covering the vicinity of the tip end of the first branch portion 601, reliability of connection strength between the first wiring body 50 and the second wiring body 60 is improved.

In this embodiment, a maximum thickness $t_1$ of the sealing resin 80 (a height from the upper surface of the first resin portion 51 to a part of the sealing resin 80 which most protrudes) is equal to or lower than the height $H_1$ from the upper surface of the first resin portion 51 to the upper surface of the third resin portion 55 ($H_1 \geq t_1$). Further, in this embodiment, the maximum thickness $t_1$ of the sealing resin 80 is equal to or lower than the height $H_2$ from the upper surface of the first resin portion 51 to the upper surface of the second resin portion 53 ($H_2 \geq t_1$). Therefore, since the sealing resin 80 does not protrude to the upper side in relation to the upper surface of the third resin portion 55, it is difficult for the sealing resin 80 to spread on the upper surface of the second resin portion 53. Thus, it is possible to obtain a wiring body that is excellent in flatness.

Further, in this embodiment, the maximum thickness $t_1$ of the sealing resin 80 is larger than the height $H_3$ from the upper surface of the first resin portion 51 to the edge portion 535 ($t_1 > H_3$). Therefore, the sealing resin 80 is in contact with the upper surface of the first branch portion 601, and reliability of connection strength between the first wiring body 50 and the second wiring body 60 is improved.

Examples of the resin material forming such a sealing resin 80 may include UV curable resins, thermosetting resins, or thermoplastic resins such as an epoxy resin, an acrylic resin, a polyester resin, a urethane resin, a vinyl resin, a silicone resin, a phenol resin, and a polyimide resin.

As illustrated in Fig. 3, the second opening portion 551 is formed in a rectangular shape in plan view and is disposed at one side of the third resin portion 55 (one side positioned at an edge portion of the first wiring body 50 intersecting the second branch portion 602). This second opening portion 551 is larger than the first opening portion 531 in plan view. Further, in plan view, the first opening portion 531 and the second opening portion 551 are overlapped. Therefore, the second terminal portion 543 is exposed from the second opening portion 551 and the first terminal portion 523 exposed from the first opening portion 531 is also exposed from the second opening portion 551.

As illustrated in Fig. 5, an end face 552 of the third resin portion 55 which defines this second opening portion 551 includes: a lower side face 553; an upper side face 554; and a edge portion 555 that connects the lower side face 553 and upper side face 554 in cross-sectional view (in cross-sectional view in the case of being cut along the extending direction of the second terminal portion 543).

The edge portion 555 protrudes toward the region of the second opening portion 551. According to this, the end face 552 is formed with a convex portion 556 protruding toward the region of the second opening portion 551. A curvature radius of this edge portion 555 is preferably 5 μm or less. A height $H_6$ from the upper surface of the second resin portion 53 to the edge portion 555 is smaller than the height $H_5$ from the upper surface of the second resin portion 53 to the upper surface of the third resin portion 55 ($H_5 > H_6$).

As illustrated in Fig. 6, this edge portion 555 is continuously formed along the horizontal direction over the entire region of three end faces 552 defining the second opening portion 551. Further, also in a part at which two end faces 552 and 552 are connected to each other, the edge portion 555 is continuously formed.

As illustrated in Fig. 5, the lower side face 553 is positioned at the lower side (a side close to the second resin portion 53) with respect to the edge portion 535. The lower side face 553 includes a curved portion 5531 that approaches the edge portion 555 as being separated from the second resin portion 53 and is curved toward the inner side of the convex portion 556. As illustrated in Fig. 7, the curved portion 5531 includes: a third part 5531a close to the edge portion 555; and a fourth part 5531b that is far from the edge portion 555, and a curvature radius of the curved portion 5531 varies in these third part 5531a and fourth part 5531b. Specifically, the curvature radius of the third part 5531a is smaller than the curvature radius of the fourth part 5531b. Since the curved portion 5531 and the curved portion 5331 are slightly different in terms of the shape but have the same basic configuration, the curved portion 5331 is illustrated in Fig. 7, and the curved portion 5531 is denoted by the symbol corresponding the symbol in parentheses, so that illustrating of the curved portion 5331 in the drawing is omitted.

As illustrated in Fig. 5, the upper side face 554 is positioned at the upper side with respect to the lower side face 553 and the edge portion 555 (a side far away from the second resin portion 53). The upper side face 554 extends in a direction different form that of the lower side face 553, and in this embodiment, the upper side face 554 is an inclined face that is inclined to be separated from the edge portion 535 as being separated from the second resin portion 53.

As illustrated in Fig. 5, in the region of the second opening portion 551, the tip end of the second branch portion 602 and the end face 552 of the second opening portion 551 are separated from each other, and according to this, a gap 92 is formed between the second branch portion 602 and the end face 552. In the gap 92, a part of the second terminal portion 543 is exposed from the second branch portion 602, the conductive bonding portion 70, and the third resin portion 55.

In the region of the second opening portion 551 including at least the gap 92, the sealing resin 80 is filled.

The second terminal portion 543 exposed from the second branch portion 602, the conductive bonding portion 70, and the third resin portion 55 is covered with the sealing resin 80.

This sealing resin 80 is in contact with the second lower side face 553 and the edge portion 555 in an interface with the end face 552 of the second opening portion 551, but the sealing resin 80 is not in contact with the upper side face 554. That is, spreading to a height direction of the sealing resin 80 in the interface with the end face 552 extends to the position of the edge portion 555.

Meanwhile, the sealing resin 80 spreads on the upper surface of the second branch portion 602 along the extending direction of the second branch portion 602. In this way, by the sealing resin 80 covering the vicinity of the tip end of the second branch portion 602, reliability of connection strength between the first wiring body 50 and the second wiring body 60 is improved.

In this embodiment, in the connection part of the first wiring body 50 and the second branch portion 602, a maximum height $t_2$ of the sealing resin 80 (a height from the upper surface of the second resin portion 53 to a part of the sealing resin 80 which most protrudes) is equal to or lower than the height $H_5$ from the upper surface of the second resin portion 53 to the upper surface of the third resin portion 55 ($H_5 \geq t_2$). Therefore, the sealing resin 80 does not protrude to the upper side in relation to the upper surface of the third resin portion 55.

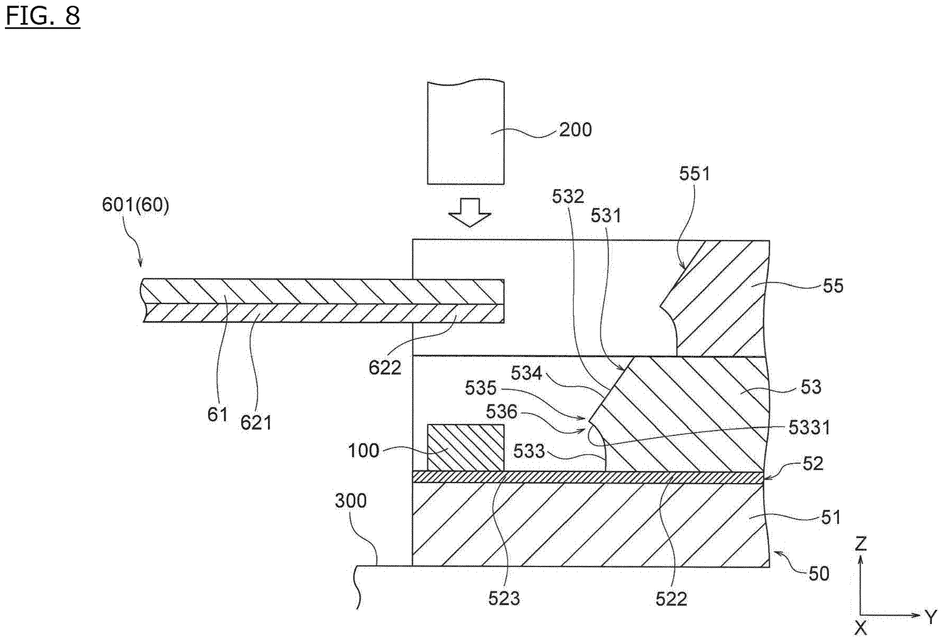

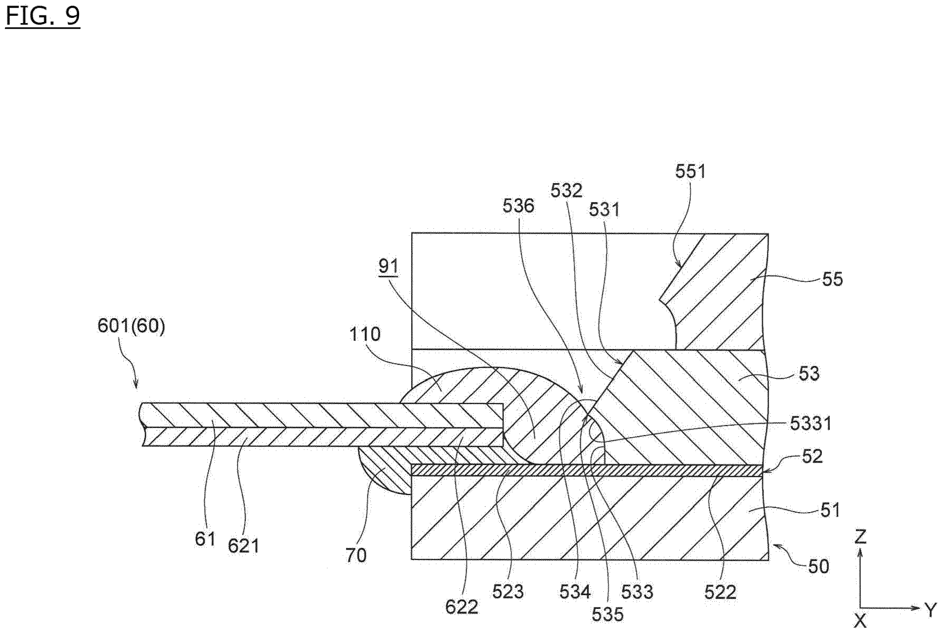

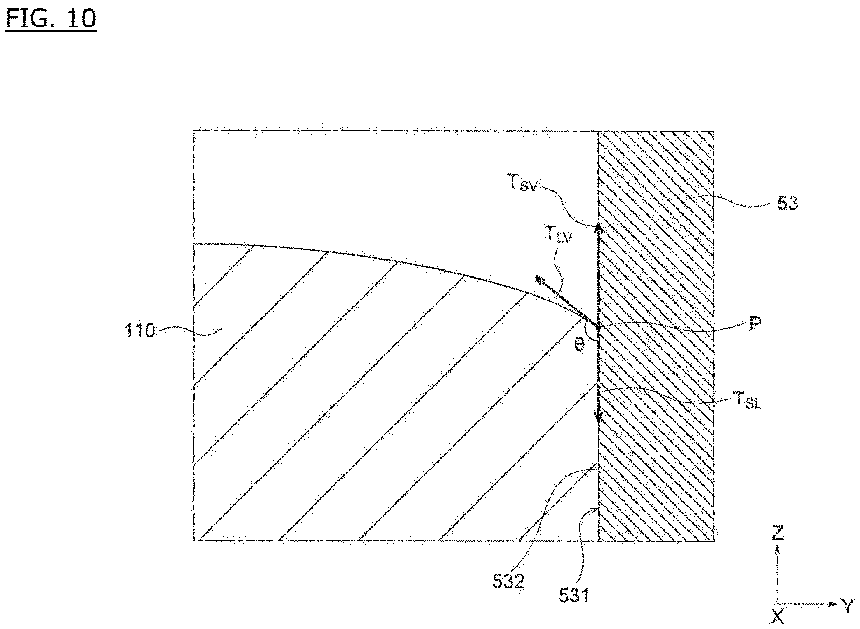

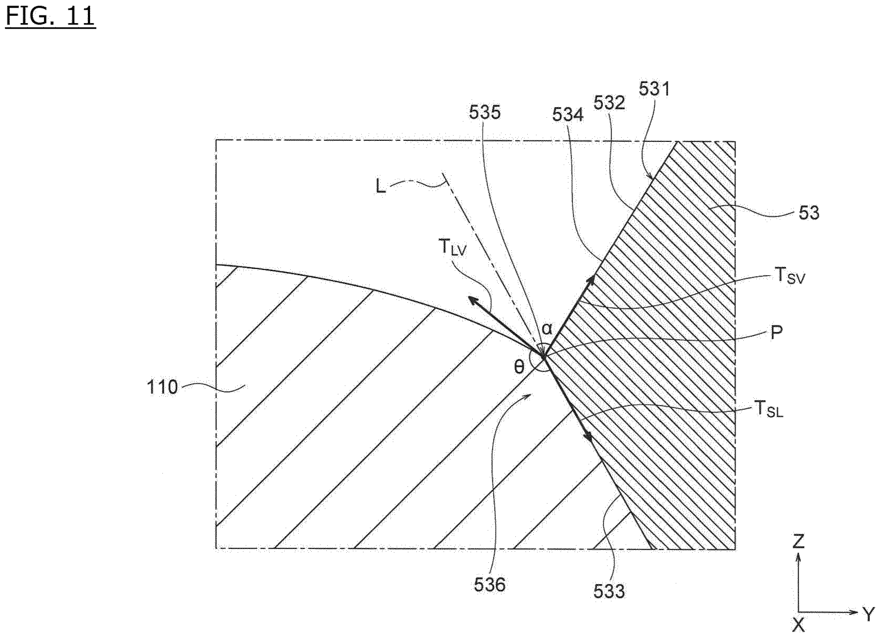

Next, operations of the first wiring body 50 and the wiring body assembly 40 of this embodiment will be described. Fig. 8 and Fig. 9 are cross-sectional views for describing a method of connecting the first wiring body and the second wiring body, Fig. 10 is a cross-sectional view illustrating a relation between a surface tension and a contact angle in an end face, and Fig. 11 is a cross-sectional view illustrating a relation between a surface tension and a contact angle at an edge portion. When the first wiring body 50 and the second wiring body 60 are connected, since the method of connecting the first wiring body 50 and the first branch portion 601 and the method of connecting the first wiring body 50 and the second branch portion 602 are same, the description of the latter connection method is omitted, and the description of the former connection method is employed.

First, the first wiring body 50 in which the end face 532 of the first opening portion 531 includes the lower side face 533, the upper side face 534 and the edge portion 535 is produced. As a method of forming the lower side face 533, the upper side face 534 and the edge portion 535 in the end face 532, the lower side face 533, the upper side face 534 and the edge portion 535 may be formed by performing a masking treatment with a cover lay, a solder resist, or the like at a position at which the lower side face 533, the upper side face 534 and the edge portion 535 are formed and processing the end face 532. The lower side face 533, the upper side face 534 and the edge portion 535 may be formed on the flat end face 532 by a printing method or other known method.

Next, as illustrated in Fig. 8, a conductive bonding material 100 such as ACF or ACP that forms the conductive bonding portion 70 is disposed in the first opening portion 531 of the first wiring body 50. Then, the vicinity of the tip end of the first branch portion 601 and the first wiring body 50 are thermal-compression-bonded by a press bonding head 200 and a press bonding table 300 in a state of interposing the conductive bonding material 100 between the vicinity of the tip end of the first branch portion 601 and the first wiring body 50. According to this, the first terminal portion 523 and the third terminal portion 622 are connected by the conductive bonding material 100.

Next, after the first terminal portion 523 and the third terminal portion 622 are connected via the conductive bonding portion 70, the sealing resin 80 is formed. In this step, as illustrated in Fig. 9, a liquid resin 110 is injected in the region of the first opening portion 531 by using a dispenser, and the gap 91 (among the first branch portion 601, the conductive bonding portion 70, and the end face 532 of the first opening portion 531) is sealed with the liquid resin 110.

Herein, regarding the liquid resin 110 at the time of injection, the position of the upper portion of the liquid resin 110 ascends along the end face 532 in proportion to the injection amount. In this case, as illustrated in Fig. 10, in a contact point P at which the upper portion of the liquid resin 110 and the end face 532 are brought into contact with each other, three phases (a solid phase (herein, the second resin portion 53), a liquid phase (herein, the liquid resin 110), and a gas phase) coexist, and a surface tension T between these three phases equilibrate as described in the following mathematical expression.

$$T_{SV} = T_{SL} + T_{LV}\cos\theta$$

$$\cos\theta = (T_{SV} - T_{SL})/T_{LV} \dots (1)$$

In the above-described Expression (1), $T_{SV}$ is a surface tension between the solid phase and the gas phase, $T_{SL}$ is a surface tension between the solid phase and the liquid phase, $T_{LV}$ is a surface tension between the liquid phase and the gas phase, and $\theta$ is a contact angle.

As long as the end face 532 is continuously formed, when the liquid resin 110 is additionally injected, the liquid resin 110 is wetted and spread toward the height direction such that the contact angle $\theta$ in the above-described Expression (1) is maintained.

Then, as illustrated in Fig. 11, when the contact point P of the upper portion of the liquid resin 110 and the end face 532 reaches the edge portion 535 by additionally injecting the liquid resin 110, the surface tension T between the three phases equilibrates as described in the following mathematical expression.

$$T_{SV}\cos\alpha = T_{SL} + T_{LV}\cos\theta$$

$$\cos\theta = (T_{SV}\cos\alpha - T_{SL})/T_{LV} \ldots (2)$$

In this embodiment, as described above, the angle $\alpha$ is a positive value, that is, a value that is larger than 0° and smaller than 180° ($0 < \alpha < \pi$). Therefore, in the above-described Expression (2), $\cos\alpha$ is larger than -1 and smaller than 1 ($-1 < \cos\alpha < 1$). Thus, when the above-described Expression (1) and the above-described Expression (2) are compared, $\cos\theta$ in the above-described Expression (2) is a smaller value than $\cos\theta$ in the above-described Expression (1). That is, in a state in which the upper portion of the liquid resin 110 reaches the edge portion 535, the contact angle $\theta$ becomes larger as compared to a state in which the liquid resin 110 is in contact with the end face 532 until the liquid resin 110 reaches the edge portion 535. According to this, at the edge portion 535, wetting and spreading of the liquid resin 110 to the height direction is limited.

Then, when injection of the liquid resin 110 is completed, a curing treatment of the liquid resin 110 is performed. According to this, the sealing resin 80 is formed. In this case, wetting and spreading of the liquid resin 110 to the height direction at the time of injection is limited by the edge portion 535 so that, in the interface with the end face 532, the sealing resin 80 is in contact with the lower side face 533 and the edge portion 535 but is not in contact with the upper side face 534. That is, spreading of the sealing resin 80 to the height direction in the interface with the end face 532 extends to the position of the edge portion 535.

As described above, in this embodiment, the end face 532 of the second resin portion 53 which defines the first opening portion 531 includes: the lower side face 533; the upper side face 534; and the edge portion 535 that connects the lower side face 533 and the upper side face 534. According to this, spreading of the liquid resin 110 to the height direction in the interface with the end face 532 is limited by the surface tension acting at the edge portion 535. As a result, it is possible to suppress that the sealing resin 80 is wetted and spreads on the upper surface of the third resin portion 55 so that flatness of the entire first wiring body 50 is impaired. In this embodiment, the upper surface of the third resin portion 55 is overlapped with the cover panel 20, but in this case, by limiting wetting and spreading of the liquid resin 110 on the upper surface of the third resin portion 55, excellent bonding property between the upper surface of the third resin portion 55 and the cover panel 20 can be secured.

Further, in this embodiment, the edge portion 535 is continuously formed along the horizontal direction over the entire region of the end face 532. In this case, the edge portion 535 extends in a direction perpendicular to a flow direction of the liquid resin 110, and thus spreading of the liquid resin 110 to the height direction in the interface with the end face 532 can be evenly limited. According to this, it is possible to more reliably suppress that the liquid resin 110 at the time of injection flows onto the upper surface of the third resin portion 55.

Further, in this embodiment, by the edge portion 535 protruding toward the region of the first opening portion 531, the convex portion 536 is formed in the end face 532, and the lower side face 533 includes the curved portion 5331 that approaches the edge portion 535 as being separated from the first resin portion 51 and is curved toward the inner side of the convex portion 536. In this case, in the interface with the end face 532, the liquid resin 110 is easily guided smoothly toward the edge portion 535. Further, in this embodiment, in this curved portion 5331, the curvature radius of the first part 5331a close to the edge portion 535 is relatively smaller than the curvature radius of the second part 5331b far from the edge portion 535. In this case, since the edge portion 535 can be formed in a precipitous shape, the surface tension acting at the edge portion 535 can be further increased. According to this, it is possible to more reliably suppress that the liquid resin 110 at the time of injection flows onto the upper surface of the third resin portion 55.

The "wiring body assembly 40" in this embodiment corresponds to an example of the "wiring body assembly" in the invention, the "first wiring body 50" in this embodiment corresponds to an example of the "first wiring body" in the invention, the "second wiring body 60" in this embodiment corresponds to an example of the "second wiring body" in the invention, and the "conductive bonding portion 70" in this embodiment corresponds to an example of the "conductive bonding portion" in the invention.

Further, in a case where the "first resin portion 51" in this embodiment is regarded as an example of the "first insulating portion" in the invention, the "first conductive portion 52" in this embodiment corresponds to an example of the "conductive portion" in the invention, the "first terminal portion 523" in this embodiment corresponds to an example of the "terminal portion" in the invention, the "second resin portion 53" in this embodiment corresponds to an example of the "second insulating portion" in the invention, the "first opening portion 531" in this embodiment corresponds to an example of the "opening portion" in the invention, the "end face 532" in this embodiment corresponds to an example of the "end face of the opening portion" in the invention, the "lower side face 533" in this embodiment corresponds to an example of the "first face" in the invention, the "curved portion 5331" in this embodiment corresponds to an example of the "curved portion" in the invention, the "first part 5331a" in this embodiment corresponds to an example of the "first part" in the invention, the "second part 5331b" in this embodiment corresponds to an example of the "second part" in the invention, the "upper side face 534" in this embodiment corresponds to an example of the "second face" in the invention, the "edge portion 535" in this embodiment corresponds to an example of the "edge portion" in the invention, the "substrate 61" in this embodiment corresponds to an example of the "substrate" in the invention, and the "third terminal portion 622" in this embodiment corresponds to an example of the "connection terminal portion" in the invention.

In a case where the "second resin portion 53" in this embodiment is regarded as an example of the "first insulating portion" in the invention, the "second conductive portion 54" in this embodiment corresponds to an example of the "conductive portion" in the invention, the "second terminal portion 543" in this embodiment corresponds to an example of the "terminal portion" in the invention, the "third resin portion 55" in this embodiment corresponds to an example of the "second insulating portion" in the invention, the "second opening portion 551" in this embodiment corresponds to an example of the "opening portion" in the invention, the "end face 552" in this embodiment corresponds to an example of the "end face of the opening portion" in the invention, the "lower side face 553" in this embodiment corresponds to an example of the "first face" in the invention, the "curved portion 5531" in this embodiment corresponds to an example of the "curved portion" in the invention, the "third part 5531a" in this embodiment corresponds to an example of the "first part" in the invention, the "fourth part 5531b" in this embodiment corresponds to an example of the "second part" in the invention, the "upper side face 554" in this embodiment corresponds to an example of the "second face" in the invention, the "edge portion 555" in this embodiment corresponds to an example of the "edge portion" in the invention, the "substrate 61" in this embodiment corresponds to an example of the "substrate" in the invention, and the "fourth terminal portion 632" in this embodiment corresponds to an example of the "connection terminal portion" in the invention.

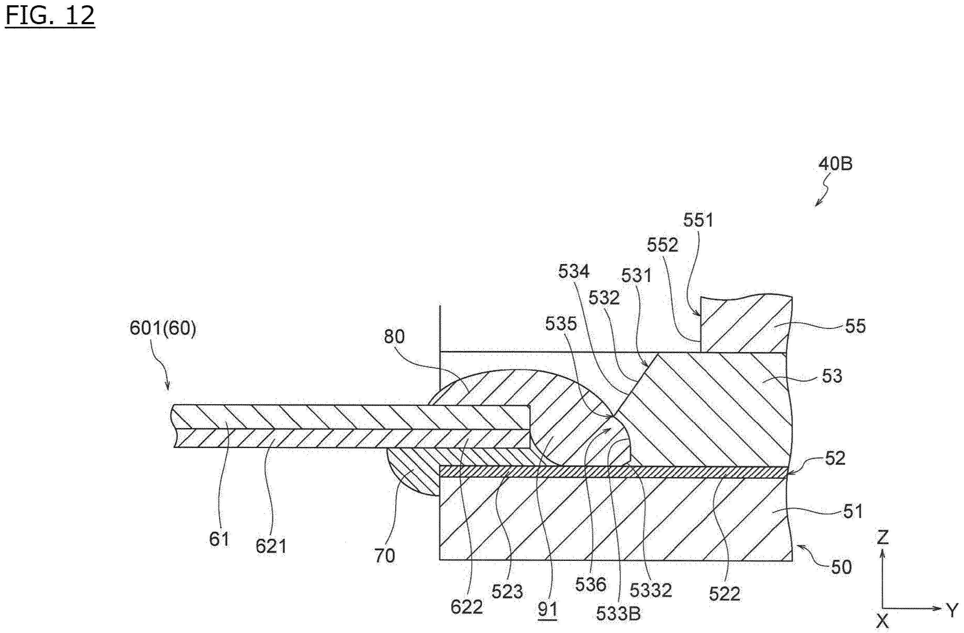

Fig. 12 is a cross-sectional view illustrating a connection part of a first wiring body and a second wiring body according to another embodiment of the invention in an enlarged manner. The same configurations as the aforementioned embodiment are denoted by the same symbols, the repeated description is omitted by referring the description in the aforementioned embodiment.

As illustrated in Fig. 12, in a wiring body assembly 40B according to this embodiment, a protrusion portion 5332 protruding toward a region of the opening portion 531 is formed at a lower end of a lower side face 533B. A lower face of the protrusion portion 5332 covers the upper surface of the first resin portion 51 and the first terminal portion 523. The upper surface of the protrusion portion 5332 faces the gap 91 and is inclined to approach the first resin portion 51 as being separated from the end face 532.

In this embodiment, since the protrusion portion 5332 is formed at the lower end of the lower side face 533B, a contact area of the second resin portion 53 and the first resin portion 51 and a contact area of the second resin portion 53 and the first terminal portion 523 can be increased. Further, since a level difference between the end face 532 and the upper surface of the first resin portion 51 can be formed in a smooth shape, convergence of stress to the level difference can be suppressed. According to this, peeling of the second resin portion 53 from the first resin portion 51 and the first terminal portion 523 can be suppressed.

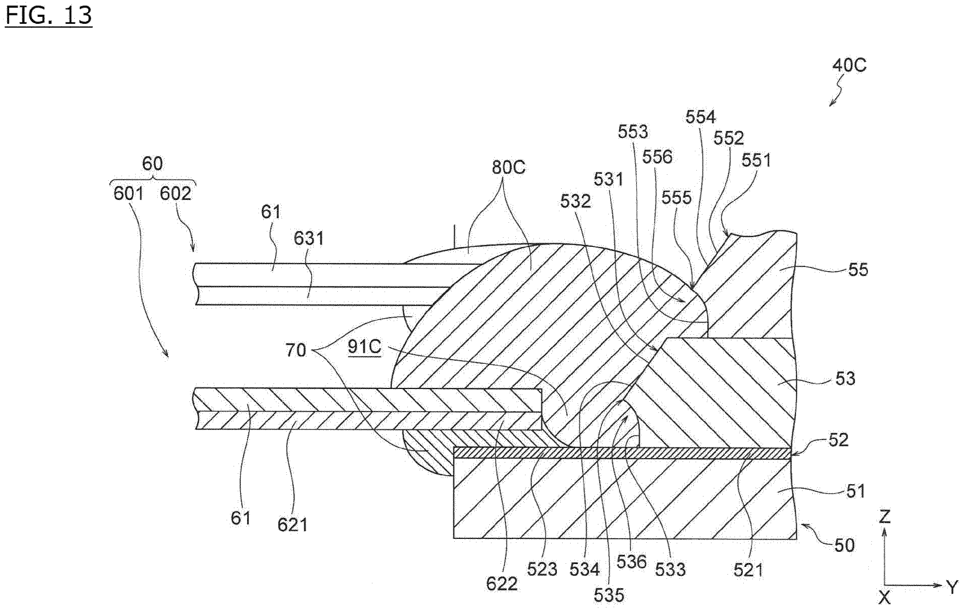

Fig. 13 is a cross-sectional view illustrating a connection part of a first wiring body and a second wiring body according to still another embodiment of the invention in an enlarged manner. The same configurations as the aforementioned embodiment are denoted by the same symbols, the repeated description is omitted by referring the description in the aforementioned embodiment.

As illustrated in Fig. 13, in a wiring body assembly 40C according to this embodiment, a sealing resin 80C collectively covers both the connection part of the first opening portion 531 and the first branch portion 601 and the connection part of the second opening portion 551 and the second branch portion 602.

In this case, the first branch portion 601 and the end face 552 of the third resin portion 55 are separated from each other, and according to this, a gap 91C is formed between the first branch portion 601 and the end face 552. In the gap 91C, a part of the first terminal portion 523 is exposed from the first branch portion 601, the conductive bonding portion 70, and the second resin portion 53. The gap 91C is filled with the sealing resin 80C, and the first terminal portion 523 exposed from the first branch portion 601, the conductive bonding portion 70 and the second resin portion 53 is covered with the sealing resin 80C.

This sealing resin 80C is in contact with the lower side face 553 and the edge portion 555 in the interface with the end face 552 of the third resin portion 55 which defines the second opening portion 551, but the sealing resin 80C is not in contact with the upper side face 554. That is, spreading to a height direction of the sealing resin 80C in the interface with the end face 552 extends to the position of the edge portion 555.

In this way, in a case where a plurality of edge portions exist in the height direction of the first wiring body 50, if spreading to a height direction of the liquid resin 110 at the time of injection can be limited in the edge portion positioned at the side close to the upper surface of the third resin portion 55 (in this embodiment, the edge portion 555), wetting and spreading of the liquid resin 110 to the upper surface of the third resin portion 55 can be suppressed.

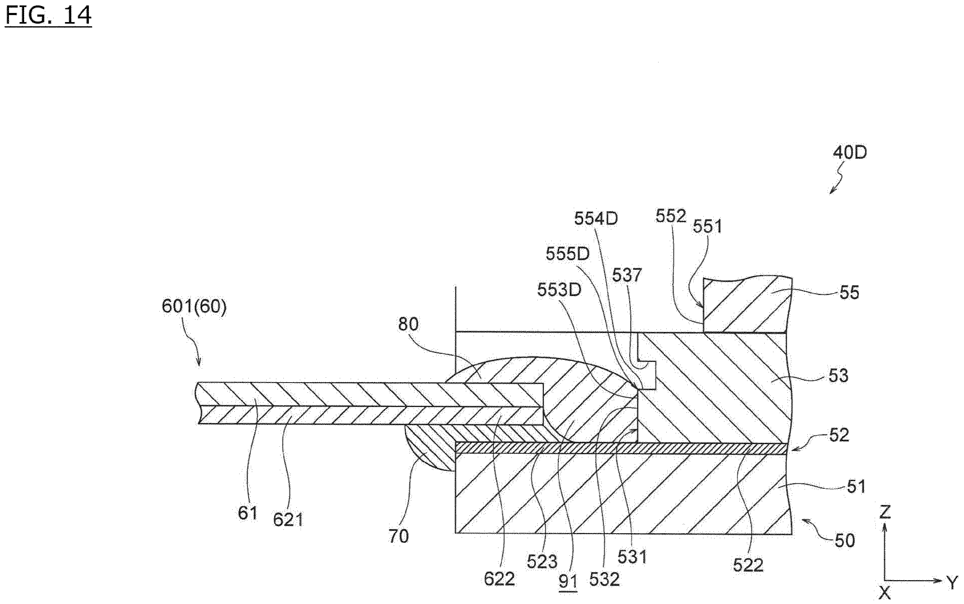

Fig. 14 is a cross-sectional view illustrating a connection part of a first wiring body and a second wiring body according to still another embodiment of the invention in an enlarged manner. The same configurations as the aforementioned embodiment are denoted by the same symbols, the repeated description is omitted by referring the description in the aforementioned embodiment.

As illustrated in Fig. 14, in a wiring body assembly 40D according to this embodiment, a concave groove portion 537 is formed in the end face 532. In this embodiment, a lower side face 533D is positioned at the lower side with respect to the groove portion 537 and extends along the height direction of the first wiring body 50. Further, an upper side face 534D extends along the wall face of the groove portion 537. Further, a edge portion 535D connecting faces of the lower side face 533D and the upper side face 534D is formed between the lower side face 533D and the upper side face 534D.

As in this embodiment, even when the edge portion 535D does not protrude to the region of the opening portion 531, spreading to the height direction of the sealing resin 80 can be limited by causing the surface tension to act on the edge portion 535D. According to this, it can be suppressed that the sealing resin 80 is wetted and spreads on the upper surface of the third resin portion 55 so that flatness of the entire first wiring body 50 is impaired.

The above-described embodiment is used to facilitate the understanding of the invention and does not limit the invention. Thus, the components disclosed in the above-described embodiment include all modifications in design and equivalents belonging to the technical scope of the invention.

For example, the touch sensor of the aforementioned embodiment is a touch sensor corresponding to a projection-type capacitive sensing method using two layers of the conductive portions 52 and 54. However, the invention is not limited thereto, and the invention is also applicable to a touch sensor corresponding to a surface-type (capacitive coupling-type) capacitive sensing method using one layer of the conductive portion.

Further, a material obtained by mixing a metal material and a carbon-based material may be used in the first conductive portion 52 and the second conductive portion 54. In this case, for example, the carbon-based material may be disposed at a top surface side of a conductor pattern, and the metal material may be disposed at a contact surface side. Reversely, the metal material may be disposed at the top surface side of a conductor pattern, and the carbon-based material may be disposed at the contact surface side.

Further, although not particularly illustrated in the drawing, the embodiment is not particularly limited to a mode in which the first wiring body 50 is pasted to the cover panel 20 in the aforementioned embodiment. For example, the first wiring body may be configured in a mode in which a release sheet is provided on a lower surface of the first resin portion 51 and the first wiring body is mounted by peeling off the release sheet and bonding the first wiring body to a mounting target (such as a film, surface glass, a polarizing plate, or display glass) at the time of mounting. Further, it is possible to employ a mode in which a resin portion covering the first wiring body 50 from the first resin portion 51 (resin portion) side is further provided, and the first wiring body is mounted by being bonded to the aforementioned mounting target through the resin portion. In these cases, the mounting target on which the wiring body is mounted corresponds to an example of a support body of the invention.

Further, the wiring body and the wiring body assembly of the embodiment described above have been described as being used in the touch sensor or the like, but is not particularly limited thereto. For example, the first wiring body may be used as a heater by energizing the first wiring body to generate heat by resistance heating or the like. In this case, it is preferable that a carbon-based material having a relatively high electrical resistance value is used as the conductive particles of the conductive portion. In addition, a part of the conductive portion of the first wiring body is grounded, and thus the first wiring body may be used as an electromagnetic shielding shield. Moreover, the first wiring body may be used as an antenna. In these case, the mounting target on which the first wiring body is mounted corresponds to an example of the support body of the invention.

EXPLANATIONS OF LETTERS OR NUMERALS

1       TOUCH SENSOR

10      WIRING BOARD

20      COVER PANEL
        21 TRANSPARENT PORTION
        22 SHIELDING PORTION

30      TRANSPARENT ADHESIVE LAYER

40      WIRING BODY ASSEMBLY
        50 FIRST WIRING BODY
        51 FIRST RESIN PORTION
        52 FIRST CONDUCTIVE PORTION
        521 FIRST ELECTRODE PORTION
        522 FIRST LEAD WIRING
        523 FIRST TERMINAL PORTION
        53 SECOND RESIN PORTION
        531 FIRST OPENING PORTION
        532 END FACE
        533 LOWER SIDE FACE
        5331 CURVED PORTION
        5331a FIRST PART
        5331b SECOND PART
        5332 PROTRUSION PORTION
        534 UPPER SIDE FACE
        535 EDGE PORTION
        536 CONVEX PORTION
        537 GROOVE PORTION
        54 SECOND CONDUCTIVE PORTION
        541 SECOND ELECTRODE PORTION
        542 SECOND LEAD WIRING
        543 SECOND TERMINAL PORTION

55 THIRD RESIN PORTION

551 SECOND OPENING PORTION

552 END FACE

553 LOWER SIDE FACE

5531 CURVED PORTION

5531a THIRD PART

5531b FOURTH PART

554 UPPER SIDE FACE

555 EDGE PORTION

556 CONVEX PORTION

60 SECOND WIRING BODY

601 FIRST BRANCH PORTION

602 SECOND BRANCH PORTION

603 SLIT

61 SUBSTRATE

62 THIRD CONDUCTIVE PORTION

621 THIRD LEAD WIRING WIRE

622 THIRD TERMINAL PORTION

63 FOURTH CONDUCTIVE PORTION

631 FOURTH LEAD WIRING WIRE

632 FOURTH TERMINAL PORTION

70 CONDUCTIVE BONDING PORTION

80 SEALING RESIN

91, 92 GAP

100     CONDUCTIVE BONDING MATERIAL

110     LIQUID RESIN

200     PRESS BONDING HEAD

300     PRESS BONDING TABLE

**Claims**

1. A wiring body comprising:

    a first insulating portion;
    a conductive portion that is formed on one surface of the first insulating portion and includes at least a terminal portion; and
    a second insulating portion that is formed on the one surface to cover the conductive portion, wherein
    the second insulating portion includes an opening portion from which the terminal portion is exposed, and
    an end face of the second insulating portion that defines the opening portion includes:

        a first face;
        a second face that is farther from the first insulating portion than the first face; and
        an edge portion that connects the first face and the second face.

2. The wiring body according to claim 1, wherein

the edge portion is continuously formed along a horizontal direction over the entire region of the end face.

3. The wiring body according to claim 1 or 2, wherein a convex portion is formed in the end face by the edge portion protruding toward the inside of the opening portion,
the first face includes a curved portion that approaches the edge portion as being separated from the first insulating portion and is curved toward the inner side of the convex portion,
the curved portion includes:

    a first part; and
    a second part that is farther from the edge portion than the first part, and
    a curvature radius of the first part is smaller than a curvature radius of the second part.

4. The wiring body according to any one of claims 1 to 3, wherein
a protrusion portion that protrudes toward the inside of the opening portion is formed at a lower end of the second face.

5. A wiring body assembly comprising:

    the first wiring body according to any one of claims 1 to 4;
    a second wiring body that includes a substrate and a connection terminal portion formed on the other surface of the substrate, the connection terminal portion being overlapped with the first wiring body in the opening portion to face the terminal portion; and
    a conductive bonding portion that is formed between the terminal portion and the connection terminal portion and connects the terminal portion and the connection terminal portion, wherein
    a gap is formed between the second wiring body and the end face by the second wiring body and the end face being separated from each other, and
    the wiring body assembly includes a sealing resin filled in at least the gap.

6. The wiring body assembly according to claim 5, wherein
the sealing resin is not in contact with the second face.

7. The wiring body assembly according to claim 5 or 6, wherein
the sealing resin is in contact with one surface of the second wiring body.

8. The wiring body assembly according to any one of claims 5 to 7, wherein
the following Expression (1) is satisfied:

$$t_1 > H_3 \cdots (1)$$

in the above Expression (1), $t_1$ is a maximum thickness of the sealing resin, and $H_3$ is a height from the one surface of the first insulating portion to the edge portion.

9. The wiring body assembly according to any one of claims 5 to 8, wherein
the following Expression (2) is satisfied:

$$H_3 < H_4 \cdots (2)$$

in the above Expression (2), $H_3$ is a height from the one surface of the first insulating portion to the edge portion, and $H_4$ is a height from the one surface of the first insulating portion to one surface of the second wiring body.

10. The wiring body assembly according to any one of claims 5 to 9, wherein
the following Expression (3) is satisfied:

$$H_2 > t_1 \cdots (3)$$

$H_2$ is a height from the one surface of the first insulating portion to one surface of the second insulating portion, and $t_1$ is a maximum thickness of the sealing resin.

FIG. 1

EP 3 573 435 A1

FIG. 2

15

FIG. 3

EP 3 573 435 A1

FIG. 4

FIG. 5

FIG. 6

FIG. 7

FIG. 8

EP 3 573 435 A1

EP 3 573 435 A1

FIG. 9

FIG. 10

EP 3 573 435 A1

FIG. 11

53
531
532
534
535
536
533
110

$T_{SV}$
$T_{SL}$
$T_{LV}$
P
L
α
θ

X Y Z

EP 3 573 435 A1

FIG. 12

FIG. 13

EP 3 573 435 A1

EP 3 573 435 A1

FIG. 14

<div align="center">

**INTERNATIONAL SEARCH REPORT**

</div>

| International application No. |
|---|
| PCT/JP2018/001154 |

| A. CLASSIFICATION OF SUBJECT MATTER |
|---|
| Int.Cl. H05K1/14(2006.01)i, G09F9/00(2006.01)i |

According to International Patent Classification (IPC) or to both national classification and IPC

| B. FIELDS SEARCHED |
|---|

Minimum documentation searched (classification system followed by classification symbols)
Int.Cl. H05K1/14, G09F9/00

| Documentation searched other than minimum documentation to the extent that such documents are included in the fields searched | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X<br>A | JP 2014-119705 A (SONY CORP.) 30 June 2014, paragraphs [0047]-[0051], fig. 11-12 & US 2014/0168916 A1, paragraphs [0094]-[0098], fig. 11-12 & CN 103885249 A & KR 10-2014-0079714 A & TW 201439652 A | 1-2, 5-8, 10<br>3-4, 9 |
| A | JP 2012-194242 A (SEIKO EPSON CORP.) 11 October 2012, paragraphs [0015]-[0022] & US 2012/0236514 A1, paragraphs [0034]-[0042] & CN 102682666 A & KR 10-2012-0105378 A & TW 201246147 A | 1-10 |
| A | JP 2010-092959 A (SONY CORP.) 22 April 2010, paragraphs [0013]-[0037] (Family: none) | 1-10 |

☐ Further documents are listed in the continuation of Box C.     ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 April 2018 (04.04.2018) | 17 April 2018 (17.04.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**REFERENCES CITED IN THE DESCRIPTION**

**Patent documents cited in the description**

- JP 2017005654 A
- JP 2001015042 A